# EUROPÄISCHE PATENTSCHRIFT

(11) **EP 2 580 778 B1**
(45) Veröffentlichungstag und Bekanntmachung des Hinweises auf die Patenterteilung: **30.07.2014**
(21) Anmeldenummer: 11733550.5
(22) Anmeldetag: 09.06.2011
(51) Int. Cl.: H01L 23/433, G03F 7/20, H01L 21/67, B23Q 1/26, H05K 7/20, F28D 21/00, F28F 7/00, F28F 13/00

(54) **WÄRMELEITELEMENT, ANORDNUNG UND VERWENDUNG DESSELBEN**
HEAT CONDUCTING ELEMENT, ARRANGEMENT AND USE OF SAME
ÉLÉMENT THERMOCONDUCTEUR, SON AGENCEMENT ET SON UTILISATION

(30) Priorität: 12.06.2010 DE 202010007905 U
(43) Veröffentlichungstag der Anmeldung: 17.04.2013
(73) Patentinhaber: Schneeberger Holding AG, 4914 Roggwil (CH)
(72) Erfinder: SCHNEEBERGER, Hans-Martin, CH-6052 Hergiswil (CH); VIX, Martin, CH-4853 Riken (CH); SCHUMACHER, Urs, CH-8008 Zürich (CH)
(74) Vertreter: EGLI-EUROPEAN PATENT ATTORNEYS
(86) Internationale Anmeldenummer: PCT/CH2011/000138
(87) Internationale Veröffentlichungsnummer: WO 2011/153654

(56) Entgegenhaltungen:
- JP-A- 3 018 790
- JP-A- 63 174 838
- US-A- 4 639 829
- US-A- 4 648 725
- US-A- 5 201 584
- US-A1- 2008 314 560
- US-A1- 2009 272 127

## Beschreibung

Die Erfindung betrifft das technische Gebiet der Wärmeleittechnik in einem Vakuum und insbesondere ein Wärmeleitelement nach Anspruch 1, sowie eine Anordnung eines solchen Wärmeleitelements nach Anspruch 7.

Aus dem Stand der Technik ist es bereits bekannt, Fluidströme wie Luft oder Wasser zur Kühlung von Bauteilen oder ganzen Aggregaten zu nutzen. Zur Kühlung elektrischer Schaltungen werden auch Peltier-Elemente eingesetzt, deren Leistungsfähigkeit allerdings begrenzt ist. Zur Abfuhr grösserer Wärmemengen aus einem Vakuum sind diese Techniken deshalb entweder nicht brauchbar oder nur sehr aufwendig oder wartungsintensiv zu realisieren. Eine bekannte Apparatus zur Wärmeabfuhr aus dem Vakuum ist in US 2009/0272127 A1 dargestellt.

Es ist Aufgabe der vorliegenden Erfindung, die Nachteile des Standes der Technik zu überwinden und ein Wärmeleitelement zur Ableitung von grösseren Wärmemengen aus einem Vakuum bereitzustellen, das konstruktiv einfach aufgebaut, zuverlässig und effizient ist, das zudem skalierbar und damit flexibel einsetzbar ist, und das praktisch wartungsfrei und somit kostengünstig betrieben werden kann.

Diese Aufgabe wird durch ein Wärmeleitelement nach Anspruch 1 gelöst.

Ein wesentlicher Punkt des erfindungsgemässen Wärmeleitelements besteht darin, dass dieses zwar ähnlich wie ein Linearlager aufgebaut ist (siehe z.B. US 5,201,584), aber auf Grund seiner Elastizität (praktisch) keine Lasten übertragen muss. Seine elastische Vorspannung wird allein genutzt, um einen guten thermischen Kontakt zwischen den beweglichen Bauteilen herzustellen. Der Wärmefluss verläuft dabei im Wesentlichen über das Stützelement, die Laufflächen und die dazwischen aufgenommenen Wälzkörper hinweg. Dabei kommt der Verbindung zwischen Stützelement und der diesem Stützelement zugewandten Lauffläche eine besondere Bedeutung zu, da beide elastisch rückfedernd gegeneinander gelagert sind. Diese kontaktieren sich so, dass zwischen diesem Stützelement und der Lauffläche eine thermische Brücke besteht. Insofern entsteht über das Wärmeleitelement hinweg eine besonders breite Kontaktfläche, die selbst eine Abfuhr grosser Wärmemengen leistet, wie sie z.B. von elektrischen Stellmotoren abgegeben wird. Der konstruktiv einfache Aufbau des Wärmeleitelements lässt zudem einen äusserst zuverlässigen Betrieb zu, der zudem kaum Wartung erfordert. Gleichzeitig ist das Element fast beliebig skalierbar, d.h. durch Anpassen seiner Abmessungen und insbesondere die Wahl der Anzahl, Art und Grösse seiner Wälzelemente an unterschiedlichste Einsatzbereiche anpassbar. Indem den Wälzkörpern ein Abstand zueinander zugestanden ist, der weniger als die Hälfte ihres jeweiligen Durchmessers beträgt, erhöht sich deren laufflächenseitige Kontaktfläche und damit der Querschnitt jedes einzelnen Wärmeleitelements, über den der Wärmefluss abgeleitet werden kann.

Bevorzugte Ausführungsformen des erfindungsgemässen Wärmeleitelements sind in den Unteransprüchen 2 bis 6 angegeben.

Grundsätzlich können die Wälzkörper jede geeignete Form aufweisen, die eine gegenseitige Bewegung der Laufflächen zueinander ermöglicht. Dafür kann natürlich eine übliche Kugelform gewählt werden. Eine besonders breite beidseitige Kontaktfläche der Wälzkörper zu den Laufflächen entsteht aber dann, wenn diese eine langgestreckte zylindrische Form aufweisen. Da die Kontaktfläche vergrössert wird, verbessert sich gleichzeitig die thermische Leitfähigkeit des erfindungsgemässen Elements.

Die Wärmeleitung zwischen dem Stützelement und der diesem Stützelement zugewandten Lauffläche wird insbesondere auch dadurch verbessert, wenn das Stützelement wenigstens einen Vorsprung und die eine der Laufflächen wenigstens eine diesem Vorsprung zugeordnete Öffnung aufweist und/oder umgekehrt, und der jeweilige Vorsprung in diese Öffnung eingreift oder diese durchgreift. Dadurch kann die thermische Brücke zwischen den beiden elastisch rückfedernd gegeneinander gelagerten Teilen deutlich vergrössert werden, was wiederum die Wärmeleitfähigkeit zwischen beiden erhöht.

Alternativ oder zusätzlich kann es auch bevorzugt sein, wenn das Stützelement die Lauffläche wenigstens teilweise und/oder die Lauffläche das Stützelement wenigstens teilweise umgreift. Auch dadurch wird die Kontaktfläche zwischen der stützelementseitigen Lauffläche und dem Stützelement selbst erhöht und die Wärmeleitfähigkeit der thermischen Brücke zwischen beiden Teilen verbessert.

Grundsätzlich können die einzelnen Teile des Wärmeleitelements aus einem Material bestehen, dessen Wärmeleitfähigkeit den spezifischen Anforderungen des geforderten Einsatzbereichs genügt. Um allerdings eine besonders gute Wärmeleitfähigkeit zu erzielen, besteht das Stützelement bevorzugt aus einem metallischen Material.

Bevorzugt ist zwischen dem Stützelement und der Lauffläche wenigstens ein Federelement vorgesehen. Je nach Anforderung können dies aber auch mehrere sein, so dass eine elastische Rückstellkraft des Wärmeleitelements flexibel anpassbar ist. Insbesondere kann durch eine besonders hohe Rückstellkraft der Kontakt zwischen den Wälzelementen und den Laufflächen verbessert werden. Gleichzeitig bilden auch die Federelemente eine thermische Brücke zwischen der Lauffläche und dem elastisch rückfedernd gegen diese Lauffläche gelagerten Stützelement. Sind die Federelemente z.B. aus besonders leitfähigem Material gefertigt, so wird mit steigender Anzahl von Federelementen auch die thermische Brücke zwischen diesen beiden Teilen verbessert.

Die eingangs genannte Aufgabe der vorliegenden Erfindung wird auch durch eine Anordnung nach Anspruch 7 gelöst.

Ein wesentlicher Punkt der erfindungsgemässen Anordnung besteht dabei darin, dass das vorstehend beschriebene Wärmeleitelement zwar ähnlich wie ein Linearlager zwischen beweglichen Bauteilen verwendet wird. Es trägt hier aber (praktisch) keine Lasten, sondern beschränkt sich auf eine reine Vorspannung. Es wirkt damit lediglich als thermische Brücke, allerdings ohne der Bewegung der Bauteile den unter Last üblicherweise entstehenden Reibungswiderstand eines Linearlagers entgegenzusetzen. Der konstruktive Aufbau des Wärmeleitelements ist damit auf thermische Optimierung bedacht, während lastbedingte Nachteile bewusst ausgeschlossen sind. Insgesamt entsteht dadurch eine optimale Wärmeableitung zwischen Bauteilen in einem Vakuum.

Bevorzugte Ausführungsformen der erfindungsgemässen Anordnung sind in den Unteransprüchen 8 und 9 angegeben.

Danach ist es von Vorteil, wenn ein Antrieb zum Bewegen der Bauteile gegeneinander zwischen diesen angeordnet ist. Die Wärme des Antriebs, z.B. eines Elektromotors, staut sich üblicherweise zwischen den Bauteilen und erhitzt insbesondere das in vertikaler Richtung gesehen obere davon. Zwischen beiden Bauteilen entstehen damit Wärmespannungen, die insbesondere bei hochpräzise arbeitenden Produktionsanlagen zu inakzeptabel hohen Materialausdehnungen mit der Folge von Bearbeitungsungenauigkeiten führen können. Während der Antrieb seine Wärme aber im Wesentlichen an das obere Bauteil abgibt, wirkt das zwischen den Bauteilen vorgespannte Wärmeleitelement dem entgegen. Dieses sorgt nämlich für eine gute Wärmeableitung vom oberen zum unteren Bauteil. Ist dieses z.B. fest verbaut, kann über dessen Basis schliesslich eine Wärmeabfuhr in die Umgebung erfolgen. Es entsteht damit ein Wärmefluss, der von dem Antrieb ausgeht, über das obere Bauteil, das erfindungsgemässe Wärmeleitelement, das untere Bauteil und in die Umgebung verläuft. Sind mehrere Wärmeleitelemente vorgesehen, kann dieser Wärmefluss noch entsprechend multipliziert werden. Mit herkömmlichen Technologien ist eine solche Wärmeableitung in einem Vakuum bislang nicht herstellbar, und zwar weder in dieser Grössenordnung, noch derart einfach und zuverlässig. Die Temperaturdifferenz zwischen den beiden Bauteilen lässt sich damit minimieren, wodurch keine Wärmespannungen mehr auftreten.

Bevorzugt ist es dabei, wenn der Antrieb räumlich näher zu dem wenigstens einen Wärmeleitelement als zu dem wenigstens einen Linearlager angeordnet ist. Damit unterliegt das Linearlager keinen unmittelbaren Wärmeeinflüssen, die seine Leistungsfähigkeit, insbesondere seine Reibungsverluste erhöhen könnten. Die Wärme wird im Gegenteil von diesem Lager weggeleitet und kann in die Umgebung abgeführt werden. Vorzugsweise soll die vorstehend beschriebene Anordnung in einer Herstellungsvorrichtung für Wafer Verwendung finden, da gerade deren hochpräzise Ausrichtung zum Laserstrahl keinen Schwankungen unterworfen sein darf.

Die vorliegende Erfindung wird im Folgenden anhand eines Ausführungsbeispiels unter Bezugnahme auf die beiliegenden Figuren im Detail erläutert. Gleiche oder funktionsgleiche Bauteile sind mit den gleichen Bezugsnummern versehen. Es zeigen:
- Figur 1: eine perspektivische Ansicht eines erfindungsgemässen Wärmeleitelements von schräg vorn und oben;
- Figur 2A: eine Vorderansicht des Wärmeleitelements der Figur 1;
- Figur 2B: eine längsgeschnittene Seitenansicht eines Teils des Wärmeleitelements der Figur 2A, und
- Figur 3: eine Vorderansicht eines Teils einer erfindungsgemässen Anordnung.

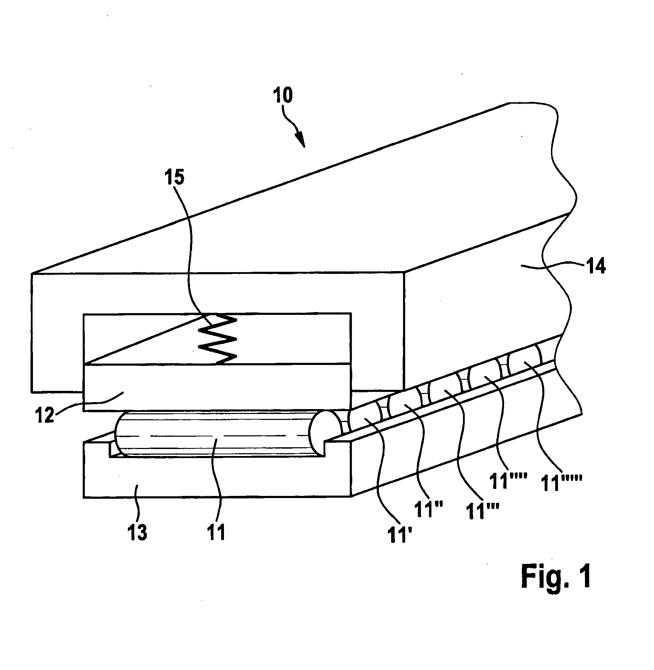

Die Figur 1 zeigt eine perspektivische Teilansicht eines erfindungsgemässen Wärmeleitelements 10 von schräg vorn und oben. Dessen Wälzelemente 11 ... 11""' sind als zylinderförmige Walzen ähnlich einem Nadellager ausgeführt und zwischen zwei Laufflächen 12 und 13 angeordnet. Die obere Lauffläche 12 wird von dem Stützelement 14 seitlich umgriffen, so dass eine seitliche thermische Brücke zwischen beiden Teilen 12 und 14 gebildet wird. Das Stützelement 10 ist dabei über ein Federelement 15 elastisch rückfedernd gegen die Lauffläche 12 gelagert. Die thermische Brücke bleibt dabei auch beim Ein- oder Ausfedern des Stützelements 14 gegen die Lauffläche 12 erhalten. Das Wärmeleitelement 10 kann deshalb zwischen zwei Bauteilen vorgespannt verbaut werden und lässt in jeder Stellung des Federelements 15 einen Wärmefluss über das Stützelement 14, das Federelement 15 und die thermische Brücke zwischen dem Stützelement 14 und der Lauffläche 12, die Wälzkörper 11 ... 11""' zur Lauffläche 13, oder umgekehrt zu. Dazu sind insbesondere das Stützelement 14, die Wälzkörper 11 ... 11"'" und die Laufflächen 12 und 13 aus einem metallischen, gut wärmeleitfähigen Material ausgeführt. Auch das Federelement 15 selbst kann zur Wärmeleitung beitragen und aus einem solchen Material bestehen, insbesondere dann, wenn ein Blattfederelement mit breiter stützelementseitiger und/oder laufflächenseitiger Kontaktfläche gewählt wird.

Die thermische Brücke zwischen dem Stützelement 14 und der zugehörigen Lauffläche 12 kann alternativ oder zusätzlich auch durch gegenüberliegende Vorsprünge oder Öffnungen (nicht gezeigt) in diesen Teilen 14 und 12 hergestellt bzw. verbessert werden, bei denen die Vorsprünge mit den jeweiligen Öffnungen in Eingriff stehen, und dies unabhängig von der jeweiligen Stellung des Federelements 15. Dadurch wird eine Fläche hergestellt bzw. weiter vergrössert, über welche die Wärme von einem in das andere Teil übertreten kann und somit die Wärmeleitfähigkeit des Wärmeleitelements deutlich verbessert.

Gleichzeitig können sich das Stützelement 14 samt Feder 15 und Lauffläche 12 gegenüber der Lauffläche 13 linear bewegen, allerdings ohne dass sie dabei Lasten aufnehmen und übertragen könnten. Eventuelle Wärmespannungen und dadurch mögliche Materialausdehnungen der einzelnen Teile werden durch das Federelement 15 kompensiert, so dass - anders als bei einem lasttragenden Linearlager - keine erhöhten Reibungswiderstände bei dieser Bewegung auftreten können. Da die Wälzkörper 11 ... 11""' von der unteren Lauffläche 13 ähnlich wie die obere Lauffläche 12 von dem Stützelement 14 umgriffen und geführt werden, entsteht zudem eine grosse Richtungsstabilität. Der einfache Aufbau lässt dabei einen (praktisch) wartungsfreien Betrieb des Wärmeleitelements 10 zu.

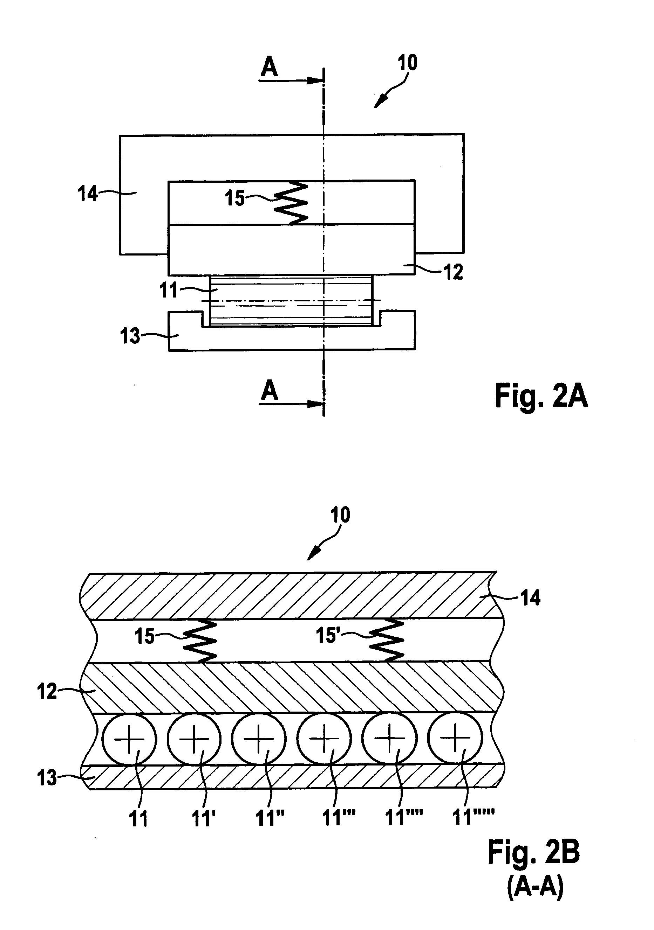

Die Figur 2A zeigt eine Vorderansicht des Wärmeleitelements 10 der Figur 1 mit den bereits bekannten Teilen 11 ... 15, die im Übrigen abhängig vom gewünschten Einsatzbereich des Elements 10 beliebig skalierbar sind. Dadurch entsteht eine erhebliche Flexibilität in der Verwendung des erfindungsgemässen Elements 10, ohne dass sein prinzipieller Aufbau verändert werden müsste. Die Figur 2B zeigt schliesslich eine längsgeschnittene Seitenansicht eines Teils des Wärmeleitelements 10 der Figur 2A entlang deren Mittellinie A-A. Im Unterschied zu den vorstehenden Figuren sind hier zwei Federelemente 15, 15` zu erkennen, die zum einen für eine besonders gute Wärmeleitung sorgen, andererseits für eine flächige Abfederung des Stützelements 14 gegen die Lauffläche 12 sorgen. Im vorgespannten Zustand des Wärmeleitelements 10 ist zudem ein besonders guter Kontakt zwischen seinen Wälzelementen 11 ... 11""' und den Laufflächen 12 und 13 sichergestellt.

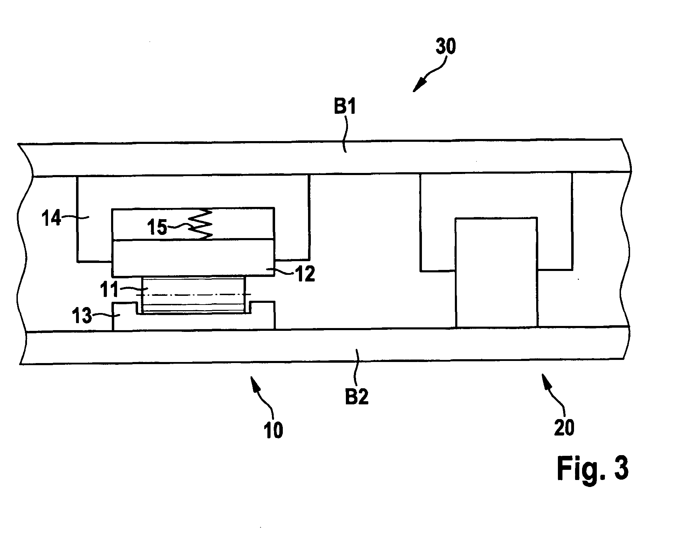

Die Figur 3 zeigt eine Vorderansicht eines Teils einer erfindungsgemässen Anordnung 30, mit dem zwischen zwei beweglichen Bauteilen B1 und B2 angeordneten Wärmeleitelement 10 und einem lasttragenden Linearlager 20. Das obere Bauteil B1 soll dabei mit Hilfe eines Antriebs (nicht gezeigt) vertikal zur Blattebene verfahrbar sein. Entsprechend sind auch das Wärmeleitelement 10 und das Linearlager 20 ausgerichtet.

Das Wärmeleitelement selbst besteht dabei aus den schon bekannten Teilen 11 ... 15 und ist idealerweise so in der Nähe eines Antriebs angeordnet, dass dessen Wärme über das obere Bauteil B1 und das Wärmeleitelement 10 hinweg zum Bauteil B2 geleitet wird. Im vorliegenden Beispiel könnte ein Antrieb z.B. zwischen dem Linearlager 20 und dem Wärmeleitelement 10 angeordnet sein. Dessen Stützelement 14 kann dabei fest mit dem oberen Bauteil B1 und dessen untere Lauffläche 13 fest mit dem Bauteil B2, z.B. durch Verschraubung verbunden sein. Ist dabei das Bauteil B2 raumfest angeordnet und das Bauteil B1 linear beweglich gelagert, kann die Wärme z.B. über eine geeignete Basis des Bauteils B2 in die Umgebung abgeleitet werden. Auf diese Weise kann eine Temperaturdifferenz zwischen den Bauteilen B1 und B2 derart minimiert werden, dass das Auftreten von Wärmespannungen zwischen diesen ausgeschlossen ist. Die Anordnung 10 eignet sich deshalb insbesondere zur Lagerung von Wafern, die auf dem Bauteil B1 verfahren und dabei unter Vakuum bearbeitet werden. Ein entsprechender Bearbeitungstisch kann z.B. in zwei Raumachsen verfahrbar sein, wobei diese Achsen in Form der erfindungsgemässen Anordnungen 30 aufgebaut sind. Dabei kann die abzuleitende Wärme auch über mehrstufig hintereinander geschaltete Wärmeleitelemente 10 geführt werden, dies auch mehrfach parallel zueinander. Der grundsätzliche Aufbau der erfindungsgemässen Anordnung 30 bleibt davon unberührt.

Konstruktive Abwandlungen des vorstehenden Ausführungsbeispiels können dabei auch eine federnde Lagerung beider Laufflächen 12 und 13 umfassen, wo immer dies durch die spezifischen Anforderungen des Einsatzbereichs erforderlich ist, ohne jedoch die wärmeableitende Wirkung des erfindungsgemässen Wärmeleitelements zu beeinträchtigen.

In jedem Fall ist eine bisher noch nicht bekannte, einfache und wirkungsvolle, dabei gleichzeitig wartungsarme und flexibel anpassbare Wärmeableitung gewährleistet.

## Patentansprüche

1. Wärmeleitelement (10) zur Anordnung zwischen beweglichen Bauteilen (B1, B2) in einem Vakuum, mit Wälzkörpern (11 ... 11""'), die zwischen zwei linear zueinander beweglichen Laufflächen (12, 13) geführt sind, und mit wenigstens einem Stützelement (14), das elastisch rückfedernd gegen eine der Laufflächen (12) gelagert ist, und das diese Lauffläche (12) so kontaktiert, dass zwischen diesem Stützelement (14) und der Lauffläche (12) eine thermische Brücke besteht, wobei die Wälzkörper (11 ... 11""') einen Abstand zueinander aufweisen, der weniger als die Hälfte ihres jeweiligen Durchmessers beträgt.

2. Wärmeleitelement (10) nach Anspruch 1, bei dem die Wälzkörper (11 ... 11"'" ) eine lang gestreckte zylindrische Form aufweisen.

3. Wärmeleitelement (10) nach Anspruch 1 oder 2, bei dem das Stützelement (14) wenigstens einen Vorsprung und die eine der Laufflächen (12) wenigstens eine diesem Vorsprung zugeordnete Öffnung aufweist und/oder umgekehrt, und der jeweilige Vorsprung in diese Öffnung eingreift oder diese durchgreift.

4. Wärmeleitelement (10) nach einem der vorstehenden Ansprüche, bei dem das Stützelement (14) die Lauffläche (12, 13) wenigstens teilweise und/oder die Lauffläche (12, 13) das Stützelement (14) wenigstens teilweise umgreift.

5. Wärmeleitelement (10) nach einem der vorstehenden Ansprüche, bei dem das Stützelement (14) aus einem metallischen Material besteht.

6. Wärmeleitelement (10) nach einem der vorstehenden Ansprüche, bei dem zwischen dem Stützelement (14) und der Lauffläche (12, 13) wenigstens ein Federelement (15, 15') vorgesehen ist.

7. Anordnung (30) aus zwei gegeneinander beweglichen Bauteilen (B1, B2) in einem Vakuum, mit wenigstens einem zwischen diesen Bauteilen (B1, B2) aufgenommenen Linearlager (20) und wenigstens einem Wärmeleitelement (10) nach einem der vorhergehenden Ansprüche, das elastisch vorgespannt zwischen den Bauteilen (B1, B2) angeordnet ist.

8. Anordnung (30) nach Anspruch 7, mit einem Antrieb zum Bewegen von wenigstens einem der Bauteile (B1, B2) gegenüber dem jeweils anderen Bauteil (B1, B2), der zwischen diesen beiden Bauteilen (B1, B2) angeordnet ist.

9. Anordnung (30) nach Anspruch 8, bei welcher der Antrieb räumlich näher zu dem wenigstens einen Wärmeleitelement (10) als zu dem wenigstens einen Linearlager (20) angeordnet ist.

10. Herstellungsvorrichtung für Wafer umfassend eine Anordnung (30) nach einem der Ansprüche 7 bis 9.

## Claims

1. A heat-conducting element (10) for arrangement between movable components (B1, B2) in a vacuum, comprising rolling elements (11 11""') which are guided between two running surfaces (12, 13) that can be moved linearly relative to each other, and further comprising at least one supporting element (14) which is mounted elastically springing back against one of the running surfaces (12) and which is in contact with said running surface (12) such that a thermal bridge exists between said supporting element (14) and the running surface (12), wherein the rolling elements (11 ... 11""') are arranged at a distance from each other which is less than half of their respective diameter.

2. A heat-conducting element (10) according to claim 1, in which the rolling elements (11 ... 11""') have an elongated cylindrical shape.

3. A heat-conducting element (10) according to claim 1 or 2, in which the supporting element (14) comprises at least one projecting part and one of the running surfaces (12) comprises at least one opening allocated to said projecting part and/or vice versa, and the respective projecting part engages with or penetrates said opening.

4. A heat-conducting element (10) according to any one of the preceding claims, in which the supporting element (14) at least partly encompasses the running surface (12, 13) and/or the running surface (12, 13) at least partly encompasses the supporting element (14).

5. A heat-conducting element (10) according to any one of the preceding claims, in which the supporting element (14) consists of a metallic material.

6. A heat-conducting element (10) according to any one of the preceding claims, in which at least one spring element (15, 15') is provided between the supporting element (14) and the running surface (12, 13).

7. An assembly (30) comprising two components (B1, B2) which are movable relative to each other in a vacuum, having at least one linear bearing (20) retained between said components (B1, B2) and at least one heat-conducting element (10) according to any of the preceding claims arranged elastically pre-loaded between the components (B1, B2).

8. An assembly (30) according to claim 7, having a drive for moving at least one of the components (B1, B2) relative to the respective other component (B1, B2), said drive being arranged between said two components (B1, B2).

9. An assembly (30) according to claim 8, in which the drive is arranged closer with respect to space to the at least one heat-conducting element (10) than to the at least one linear bearing (20).

10. A manufacturing device for wafers comprising an assembly (30) according to any one of claims 7 to 9.

## Revendications

1. Elément thermoconducteur (10) destiné à être disposé entre des composants (B1, B2) mobiles dans un vide avec des corps de roulement (11 ... 11""') qui sont guidés entre deux surfaces de roulement (12, 13) linéairement mobiles entre elles et avec au moins un élément de support (14) qui est monté de façon à rebondir élastiquement contre une des surfaces de roulement (12) et qui entre en contact avec cette surface de roulement (12) de telle sorte qu'il existe un pont thermique entre cet élément de support (14) et la surface de roulement (12), les corps de roulement (11 ... 11""') présentant un espacement entre eux qui est inférieur à la moitié de leur diamètre respectif,

2. Elément thermoconducteur (10) selon la revendication 1 pour lequel les corps de roulement (11 ... 11""') présentent une forme cylindrique allongée en longueur,

3. Elément thermoconducteur (10) selon la revendication 1 ou 2 pour lequel l'élément de support (14) présente au moins une partie en saillie et la une des surfaces de roulement (12) au moins une ouverture attribuée à cette partie en saillie et/ou inversement et la partie en saillie respective vient en prise dans cette ouverture ou pénètre celle-ci.

4. Elément thermoconducteur (10) selon une quelconque des revendications précédentes pour lequel l'élément de support (14) enveloppe la surface de roulement (12, 13) au moins en partie et/ou la surface de roulement (12, 13) enveloppe l'élément de support (14) au moins en partie.

5. Elément thermoconducteur (10) selon une quelconque des revendications précédentes pour lequel l'élément de support (14) est fait d'un matériau métallique.

6. Elément thermoconducteur (10) selon une quelconque des revendications précédentes pour lequel au moins un élément à ressort (15, 15') est prévu entre l'élément de support (14) et la surface de roulement (12, 13).

7. Montage (30) composé de deux composants (B1, B2) mobiles l'un par rapport l'autre dans un vide avec au moins un palier linéaire (20) logé entre ces composants (B1, B2) et au moins un élément thermoconducteur (10) selon une quelconque des revendications précédentes qui est monté élastiquement précontraint entre les composants (B1. B2).

8. Montage (30) selon la revendication 7 avec un mécanisme d'entraînement pour déplacer au moins un des composants (B1, B2) par rapport à chaque fois à l'autre composant (B1, B2) qui est disposé entre ces deux composants (B1, B2).

9. Montage (30) selon la revendication 8 pour lequel le mécanisme d'entraînement est disposé dans l'espace plus près du au moins un élément thermoconducteur (10) que du au moins un palier linéaire (20).

10. Dispositif de fabrication pour tranches comprenant un montage (30) selon une quelconque des revendications 7 à 9.
